# DEMANDE DE BREVET EUROPEEN

(11) **EP 1 630 854 A2**
(43) Date de publication de la demande: **01.03.2006**
(21) Numéro de dépôt: 05107437.5
(22) Date de dépôt: 12.08.2005
(51) Int. Cl.: H01L 21/00

(54) **Interface sous vide entre une boîte de mini-environnement et un équipement**

(30) Priorité: 30.08.2004 FR 0451932
(71) Demandeur: ALCATEL, 75008 Paris (FR)
(72) Inventeur: Le Guet, Catherine, 73290, La Motte-Cervolex (FR); Desbiolles, Jean-Pierre, 74350, Cruseilles (FR); Kambara, Hisanori, 74350, Villy-Le-Pelloux (FR); Godot, Erwan, 71710 Montcenis (FR); Sylvestre, Raphaël, 26800 Montoison (FR)
(74) Mandataire: Lamoureux, Bernard

(57) **Abrégé**

Dans un dispositif selon l'invention, une boîte de transport (1) peut être accouplée à l'ouverture de passage (11) d'un appareil de traitement (9), de manière étanche par interposition d'un joint périphérique d'interface (16). La porte de boîte (4) peut être solidarisée sélectivement à la porte d'interface (12) pour un déplacement en bloc selon un mouvement axial suivi d'un mouvement transversal, entraînée par des moyens d'actionnement de porte (14). La boîte de transport (1) est retenue par un moyen de retenue (15). Le volume périphérique (21) autour des deux portes peut être pompé par une pompe (22) et une canalisation (23). Sur la boîte de transport (1), la porte de boîte (4) peut être verrouillée par des moyens de verrouillage (20), assurant une bonne étanchéité pendant que la boîte de transport (1) est à l'écart de l'appareil de traitement (9).

On assure ainsi une bonne étanchéité de la boîte de transport (1), et on permet l'ouverture sous vide des portes (4,12) sans pollution de l'atmosphère intérieure.

## Description

La présente invention concerne le transport d'objets plats tels que des plaquettes de semi-conducteur ou des masques dans des boîtes de transport à ouverture frontale, notamment des boîtes à ouverture latérale de type FOUP (Front Opening Universal Pod) ou des boîtes à ouverture inférieure de type SMIF, entre les étapes successives d'un procédé de fabrication de semi-conducteurs.

Le transport des plaquettes et des masques dans des boîtes de transport de type FOUP ou de type SMIF est couramment utilisé pour protéger les plaquettes et les masques contre les pollutions résiduelles présentes dans les salles blanches. La boîte de transport isole les plaquettes et les masques vis-à-vis de l'atmosphère régnant dans la salle blanche.

Dans les procédés actuellement les plus couramment utilisés, les plaquettes et les masques sont transportés dans une boîte de transport de type FOUP ou de type SMIF qui peut être ouverte après accouplement à une interface située à l'entrée d'un équipement. La boîte de transport est toujours à pression atmosphérique, et son atmosphère intérieure est également à pression atmosphérique d'air ou d'azote.

Un exemple d'une telle boîte est décrit dans les documents US-2001/0041530 et EP-1 204 138. La boîte de transport comporte une paroi périphérique étanche à ouverture d'entrée-sortie obturable par une porte de boîte à moyens d'étanchéité frontale et des moyens d'étanchéité périphériques pour isoler de l'atmosphère extérieure la zone d'accouplement avec l'interface.

L'interface est un système permettant le positionnement de la boîte de transport, l'ouverture de sa porte de boîte, et la préhension et le transport d'un objet plat pour un transfert entre la boîte de transport et l'équipement.

Habituellement, l'interface de l'équipement est elle-même munie d'un robot assurant la préhension et le déplacement des objets plats entre la boîte de transport et une chambre de mise sous vide de l'équipement. Après passage dans l'interface, l'objet plat est transféré dans la chambre de mise sous vide de l'équipement.

La chambre de mise sous vide de l'équipement est remise périodiquement à la pression atmosphérique, de manière à être connectée à l'interface de l'équipement pour le transfert des objets plats. La chambre de mise sous vide est également remise périodiquement sous vide de manière à assurer la communication avec une chambre de traitement de l'équipement pour le transfert des objets plats. Ces variations de pression gazeuse nécessitent des opérations de pompage et de remise à pression atmosphérique qui prennent du temps et provoquent des flux gazeux. De tels flux gazeux peuvent générer un déplacement de particules, et provoquer ainsi une contamination particulaire des objets plats. D'autre part, quand l'objet plat est à la pression atmosphérique, il peut subir une contamination par les molécules présentes dans l'atmosphère. La contamination peut concerner l'interface, la boîte de transport, et les objets plats.

Pour améliorer l'isolement assuré par la boîte de transport vis-à-vis de l'atmosphère, on a déjà imaginé, dans le document US 5,382,127, d'utiliser des boîtes de transport dont l'atmosphère intérieure est en surpression vis-à-vis de l'atmosphère externe. Cette solution n'est pas satisfaisante, car, pour la communication avec l'équipement, il reste nécessaire d'assurer un pompage de l'atmosphère intérieure de la boîte de transport, ce qui implique la création de flux gazeux qui restent susceptibles de provoquer des contaminations particulaires.

L'invention vise à éviter les inconvénients de l'état de la technique en permettant en particulier de réduire de façon très sensible les risques de contamination résultant des pompages et mises à pression atmosphérique périodiques des objets plats dans les chambres de chargement ou d'interface, lors des opérations de transfert entre la boîte de transport et un équipement.

Il est particulièrement nécessaire de limiter les contaminations possibles, de façon à augmenter la productivité des installations de fabrication de semi-conducteurs.

L'invention vise également à diminuer les temps de traitement dans les équipements, en diminuant les temps de pompage et de dégazage.

L'invention vise enfin à simplifier les équipements, en supprimant si possible les chambres de transfert.

L'idée essentielle qui est à la base de l'invention est de réaliser le transport des objets plats tels que les plaquettes ou masques dans une atmosphère de vide qui soit la plus proche possible de l'atmosphère présente dans les équipements, et de réaliser l'accouplement des boîtes de transport avec les équipements par des moyens assurant l'étanchéité permanente vis-à-vis de l'atmosphère extérieure dans la salle blanche.

De la sorte, la boîte de transport est chargée et déchargée sous vide. Il en résulte des contraintes réduites sur les plaquettes ou masques contenus dans la boîte de transport et transférés entre la boîte de transport et l'équipement.

On peut donc prévoir que la boîte de transport soit munie de moyens pour faire ou entretenir le vide pendant le transport. Avantageusement, la mise sous vide de la boîte de transport peut être assurée au départ par un système de pompage connecté à l'interface de transfert sur l'équipement.

De la sorte, la boîte de transport devient une boîte de chargement mobile.

Mais une difficulté est d'assurer l'ouverture des portes de la boîte de transport et de l'interface, pour permettre une communication et le passage des objets plats, tout en maintenant des conditions d'étanchéité vis-à-vis de l'atmosphère extérieure régnant dans la salle blanche.

Une autre difficulté est d'assurer une étanchéité suffisante de la boîte de transport, pour maintenir l'atmosphère intérieure à basse pression pendant une durée suffisante, durée permettant non seulement le transport, mais également des périodes de stockage entre des étapes successives de traitement des objets plats. A cet égard, on pourrait imaginer que la pression atmosphérique par rapport au vide intérieur d'une boîte de transport peut suffisamment comprimer des joints d'étanchéité d'une porte pour que celle-ci assure une fermeture suffisamment étanche de la boîte de transport pendant un transport. Mais l'expérience montre qu'une telle solution n'est pas fiable, notamment par le fait que les défauts d'étanchéité peuvent être cumulatifs, un défaut d'étanchéité provoquant une augmentation de la pression interne de la boîte de transport, qui à son tour réduit la force de compression des joints d'étanchéité qui se trouvent alors eux-mêmes moins étanches et augmentent les risques de fuite.

Une autre difficulté est que les faces externes des portes d'interface et de boîte de transport sont nécessairement au contact de l'atmosphère moins propre régnant dans la salle blanche, pendant les périodes au cours desquelles la boîte de transport est à l'écart de l'équipement. Des particules polluantes peuvent ainsi se déposer sur les faces externes des portes. Ensuite, lorsqu'on réalise une étanchéité, vis-à-vis de l'atmosphère extérieure, de la zone entourant les portes, il faut aussi éviter que les surfaces externes des portes viennent au contact de l'atmosphère intérieure régnant dans la boîte de transport et dans l'équipement, qui sont mis en communication lors de l'ouverture des portes. Les particules déposées sur les faces externes des portes risquent en effet de s'échapper et de polluer l'atmosphère intérieure des boîtes de transport et des équipements, ainsi que les objets plats.

Une autre difficulté est également que tout déplacement de pièces mécaniques telles que des verrous, des joints d'étanchéité, des portes, peut produire, en cas de frottement, des émissions de particules polluantes susceptibles de dégrader l'atmosphère intérieure des boîtes de transport et des équipements, ainsi que les objets plats à traiter.

Une autre difficulté est d'assurer un conditionnement correct de la boîte de transport et de l'interface, pour éviter les risques de contamination des objets plats lors de leur transfert entre la boîte de transport et l'équipement. Il convient en particulier d'éviter que des particules se déposent sur les objets plats pendant le transfert, ou que des gaz ou de l'humidité se condense sur les objets plats.
L'invention vise ainsi à éviter tous ces inconvénients, de façon à limiter tous types de contamination, pour augmenter la productivité des installations de fabrication de semi-conducteurs.

Pour atteindre ces buts ainsi que d'autres, l'invention propose un dispositif de transport d'objets plats tels que des plaquettes ou masques vers ou à l'écart d'un équipement, comprenant :
- des boîtes de transport ayant chacune une paroi périphérique étanche à ouverture d'entrée-sortie obturable par une porte de boîte à moyens d'étanchéité frontale de porte de boîte,
- à l'entrée de l'équipement, une interface munie d'une ouverture de passage obturable par une porte d'interface à moyens d'étanchéité frontale de porte d'interface,
- des moyens d'étanchéité périphérique pour isoler de l'atmosphère extérieure une zone d'accouplement entre les faces frontales de la boîte de transport et de l'interface autour des ouvertures de passage et d'entrée-sortie,
- des moyens d'actionnement de portes, adaptés dans l'interface, pour déplacer la porte de boîte et la porte d'interface entre une position fermée et une position ouverte déportée vers l'intérieur de l'interface,
- des moyens de verrouillage de porte de boîte, prévus dans la boîte de transport, actionnables par des moyens d'actionnement montés dans l'interface, pour verrouiller et déverrouiller sélectivement la porte de boîte en position fermée dans laquelle elle obture l'ouverture d'entrée-sortie,

caractérisé en ce que ledit dispositif, étant destiné au transport d'objets sous atmosphère à basse pression, comprend en outre
- des boîtes de transport (1) qui sont structurées pour supporter mécaniquement la pression atmosphérique externe en présence d'un vide dans sa cavité interne (6),
- des moyens pousseurs, adaptés dans l'interface pour appliquer sur la porte de boîte une poussée axiale vers l'intérieur de la boîte de transport, pour comprimer les moyens d'étanchéité frontale de porte de boîte, et
- des moyens d'étanchéité frontale de porte de boîte élastiquement compressibles, et agencés pour être maintenus élastiquement comprimés par la porte de boîte elle-même retenue par les moyens de verrouillage de porte de boîte lorsque la porte de boîte est en position fermée verrouillée.

Dans cette description, l'expression "équipement" désigne toute structure à laquelle on désire accoupler sélectivement une boîte de transport pour un transfert d'objets plats. Un tel équipement peut, par exemple, être une enceinte de mini-environnement munie elle-même d'un robot de manipulation d'objets plats. Cela peut être une chambre de transfert (load lock). Mais cela peut être également toute autre chambre sous vide.

La qualification "frontale" désigne une orientation perpendiculaire à l'axe de passage dans l'ouverture de passage ou dans l'ouverture d'entrée-sortie. Ainsi, l'orientation "frontale" sera disposée selon un plan vertical, dans le cas d'une boîte de transport de type FOUP à ouverture latérale, et sera disposée selon un plan horizontal dans le cas d'une boîte de transport de type SMIF à ouverture inférieure.

Une telle combinaison de moyens, avec des joints comprimés, permet d'assurer une étanchéité satisfaisante de la boîte de transport, pour maintenir un vide approprié dans la boîte de transport pendant une durée pouvant couvrir non seulement une période de transport mais également une période assez longue d'entreposage.

De préférence, les moyens pousseurs permettent d'appliquer sur la porte de boîte une poussée axiale d'intensité suffisante qui comprime les moyens d'étanchéité frontale de porte de boîte au-delà de la compression assurée par les moyens de verrouillage de porte de boîte. Une telle disposition est favorable pour faciliter le verrouillage et le déverrouillage, et en particulier pour permettre d'assurer le verrouillage et le déverrouillage sans que les pièces mécaniques subissent des frottements susceptibles de produire des particules polluantes.

En pratique, pour assurer un verrouillage et un déverrouillage sans frottement, les moyens pousseurs sont de préférence adaptés pour :
- lors d'une étape de verrouillage de la porte de boîte appliquer ladite poussée axiale d'intensité suffisante sur la porte de boîte, puis actionner les moyens de verrouillage de porte de boîte pour verrouiller la porte de boîte, et enfin relâcher ladite poussée axiale,
- lors d'une étape de déverrouillage de la porte de boîte, appliquer ladite poussée axiale d'intensité suffisante sur la porte de boîte, puis actionner les moyens de verrouillage pour déverrouiller la porte de boîte, et enfin relâcher ladite poussée axiale.

La manoeuvre de la porte de boîte et de la porte d'interface doit être assurée par des moyens d'actionnement prévus dans l'interface. Pour cela, on peut avantageusement prévoir des moyens d'accouplement détachables adaptés dans la porte de boîte et dans la porte d'interface, commandés par les moyens d'actionnement de porte, pour solidariser de manière réversible la porte de boîte contre la porte d'interface. De la sorte, à l'état accouplé, la porte de boîte se déplace en bloc avec la porte d'interface entre la position fermée et la position ouverte.

On peut avantageusement profiter de l'accouplement des deux portes l'une sur l'autre pour favoriser également l'étanchéité de la porte d'interface. Pour cela, on peut prévoir que :
- les moyens d'étanchéité frontale de porte d'interface sont élastiquement compressibles,
- à l'état accouplé, la poussée axiale d'intensité suffisante produit simultanément la compression du moyen d'étanchéité frontale de porte d'interface.

Les moyens de poussée font également office de butée de retenue pour conserver la position de la porte d'interface.

On peut également profiter de l'accouplement des deux portes l'une sur l'autre pour simplifier les moyens d'actionnement des portes : les deux portes d'actionnement ensemble peuvent être déplacées par des moyens agissant seulement sur la porte d'interface.

Mais il faut également que les moyens d'actionnement assurent la production de ladite poussée axiale d'intensité suffisante pour comprimer les moyens d'étanchéité frontale. Dans un premier mode de réalisation, les moyens d'actionnement de porte comprennent :
- les premiers moyens d'actionnement assurant le déplacement des portes entre les positions ouverte et fermée,
- des seconds moyens d'actionnement, distincts des premiers moyens d'actionnement, et assurant ladite poussée axiale d'intensité suffisante.

L'avantage est que les seconds moyens d'actionnement, qui assurent la poussée axiale d'intensité suffisante, peuvent produire un mouvement à course courte mais avec une force relativement importante, et surtout avec un bon équilibrage pour que la porte de boîte soit bien dans l'axe de l'ouverture qu'elle ferme.

En alternative, des mêmes moyens d'actionnement de porte peuvent assurer à la fois le déplacement des portes entre les positions ouverte et fermée et l'application de ladite poussée axiale d'intensité suffisante.

Selon un mode de réalisation avantageux, le dispositif comprend :
- un moyen de retenue, adapté pour solidariser de manière réversible la boîte de transport contre la paroi entourant l'ouverture de passage,
- un moyen d'étanchéité frontale d'interface pour assurer, entre la boîte de transport et la paroi entourant l'ouverture de passage, une étanchéité vis-à-vis de l'atmosphère extérieure autour des ouvertures d'entrée-sortie et de passage lorsque la boîte de transport est solidarisée contre ladite paroi.

L'invention prévoit en outre des moyens pour réduire encore le risque d'échappement de particules polluantes vers l'atmosphère intérieure de la boîte de transport et de l'équipement, et en particulier pour réduire le risque d'échappement de particules provenant des zones externes polluées des portes de boîte et d'interface. Pour cela, selon un mode de réalisation avantageux, le dispositif de l'invention comprend en outre des moyens de pompage de liaison, adaptés pour pomper le volume périphérique gazeux emprisonné dans la zone inter-joints entre la porte de boîte, la porte d'interface, le moyen d'étanchéité frontale de porte de boîte, le moyen d'étanchéité frontale de porte d'interface et le moyen d'étanchéité frontale d'interface, lorsque la boîte de transport est solidarisée contre la paroi frontale d'interface et que les portes sont en position fermée.

Dans ce cas, de préférence, à l'état accouplé, la face externe de la porte d'interface est directement en appui sur la face externe de la porte de boîte qu'elle recouvre sans jeu et sans dépassement.

La production de particules polluantes dans l'atmosphère intérieure peut également provenir, selon l'invention, de certains frottements se produisant sur les moyens d'étanchéité des portes. L'invention prévoit ainsi des moyens pour réduire tous risques de frottement. Notamment, selon un mode de réalisation avantageux, les moyens d'actionnement des portes assurent le déplacement des portes en deux mouvements partiels, à savoir un mouvement partiel axial entre la position fermée et une position de retrait axial vers l'intérieur de l'appareil de traitement, et un mouvement partiel transversal entre la position de retrait axial et une position escamotée latéralement qui libère le passage des objets plats entre la boîte de transport et l'appareil de traitement. Grâce au mouvement axial, la compression des joints s'effectue sans frottement transversal, ce qui réduit autant que possible la production de particules polluantes par frottement.

Selon une application avantageuse, les moyens d'actionnement de porte sont prévus dans une interface sous vide rapportée à l'entrée d'un équipement, tel que chambre de transfert ou chambre de procédés ou encore chambre sous vide. Un robot de manipulation des objets plats est prévu dans la boîte de transport ou dans l'interface ou de préférence dans l'équipement. Une telle interface remplace ainsi les chambres de chargement qui, dans l'état actuel de la technique, doivent être équipés d'une interface et de moyens de pompage pour un fonctionnement alterné à pression atmosphérique et à pression basse.

Dans certains cas, il pourrait arriver que la porte de boite soit mal repositionnée. La porte de boite peut alors entrer directement en contact avec la boite, et les frottements ainsi créés sont une source importante de particules. Dans le pire des cas, la porte de boite pourrait même se coincer. Le désalignement de la porte de boite peut aussi entraîner le désalignement des moyens de verrouillage de porte de boite par rapport à l'alignement des moyens d'accouplement détachables, empêchant le verrouillage ou déverrouillage de la porte de boite. Enfin si la porte de boite et la porte d'interface ne sont pas parallèles, les moyens d'étanchéité (joints) peuvent alors être sollicités en torsion ou peuvent rouler dans leurs gorges. Il en résulte la création de particules et une usure rapide et importante de ces joints.

Selon un mode particulier de réalisation de l'invention, on prévoit en outre au moins un moyen de centrage dans la porte d'interface et/ou dans la porte de la boite pour guider la porte de boite vers la porte d'interface, et les maintenir lorsque que les deux portes sont accouplées.

De préférence on prévoit au moins un moyen de centrage dans la porte d'interface comprenant un pion à tête sphérique et un ressort logé dans le logement de la porte d'interface formant guide, et au moins un moyen de centrage dans la porte de boite comprend un logement adapté pour recevoir le moyen de centrage correspondant de la porte d'interface.

De préférence encore les moyens de centrage prévus dans la porte d'interface comprennent chacun un pion à tête sphérique et un ressort logé dans le logement de la porte d'interface prévu à cet effet. Les moyens de centrage de la porte d'interface sont situés de préférence à proximité des moyens d'accouplement détachables et à l'extérieur. Cette disposition permet de mieux contrôler le parallélisme des portes entre elles.

Les moyens de centrage prévus dans la porte de boite comprennent préférentiellement deux logements correspondants aux moyens de centrage de la porte d'interface. Ces logements sont adaptés pour recevoir les logements des moyens de centrage de la porte de boite. Ils sont préférentiellement en forme de cône ce qui permet de recevoir et bloquer la tête du pion de la porte de l'interface.

D'autres objets, caractéristiques et avantages de la présente invention ressortiront de la description suivante de modes de réalisation particuliers, faite en relation avec les figures jointes, parmi lesquelles :
- la figure 1 est une vue de côté schématique en coupe longitudinale d'une boîte de transport accouplée à un équipement, dans un mode de réalisation de la présente invention, les portes de boîte et d'interface étant en position fermée,
- la figure 2 est une vue similaire de la figure 1, les portes de boîte et d'interface étant en position escamotée,
- la figure 3 est une vue similaire de la figure 1, la boîte de transport étant fermée par sa porte de boîte, l'interface étant fermée par sa porte d'interface, la boîte de transport étant à l'écart de l'interface,
- la figure 4 est une vue à plus grande échelle montrant le détail des portes et des moyens d'étanchéité, lorsque la boîte de transport est à l'écart de l'interface,
- la figure 5 est une vue similaire de la figure 4, au cours d'une étape d'accouplement dans laquelle les deux portes sont encore verrouillées, la boîte de transport étant solidarisée à l'interface,
- la figure 6 est une autre vue similaire de la figure 4, avec les deux portes accouplées l'une à l'autre et déverrouillées, la figure illustrant les mouvements des portes,
- les figures 7a, 7b, 7c et 7d illustrent quatre étapes successives de fonctionnement de moyens d'actionnement des portes selon un mode de réalisation de la présente invention,
- les figures 8a, 8b, 8c et 8d illustrent quatre étapes successives de fonctionnement d'un mécanisme d'actionnement de porte selon un autre mode de réalisation de l'invention,
- la figure 9 est une vue en perspective illustrant une interface selon un mode de réalisation de la présente invention,
- la figure 10 est une vue de côté de l'interface de la figure 9, montrant le mécanisme d'actionnement de porte,
- la figure 11 est une vue de dessus en coupe de l'interface de la figure 9, associée à une boîte de transport, les portes étant fermées verrouillées,
- la figure 12 est une vue du détail A de la figure 11, montrant schématiquement la structure des moyens de poussée et de verrouillage de porte d'interface, et
- la figure 13 illustre en vue de côté un dispositif selon un autre mode de réalisation de l'invention,
- la figure 14 est une vue de dessus schématique en coupe d'un mode de réalisation particulier de l'invention.

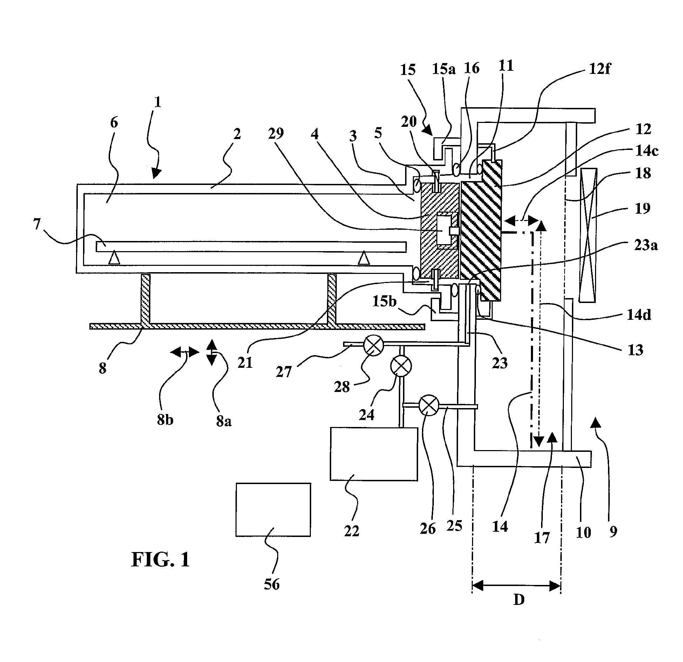

On considère tout d'abord la figure 1, qui est une vue schématique de côté en coupe longitudinale d'un dispositif de transport selon un mode de réalisation de la présente invention.

On a représenté une boîte de transport 1 à ouverture latérale, ayant une paroi périphérique étanche 2 à ouverture d'entrée-sortie 3 obturable par une porte de boîte 4 assortie de moyens d'étanchéité frontale de porte de boîte 5.

La boîte de transport 1 doit avoir une structure mécaniquement résistante pour supporter la pression atmosphérique externe en présence d'un vide dans sa cavité interne 6.

Dans la cavité interne 6, on a représenté un objet plat 7 tel qu'une plaquette de semi-conducteur ou un masque, disposé dans la boîte de transport 1 pour son déplacement entre deux sites successifs.

La boîte de transport 1 repose sur un support de boîte 8 mobile verticalement et horizontalement comme illustré par les flèches 8a et 8b.

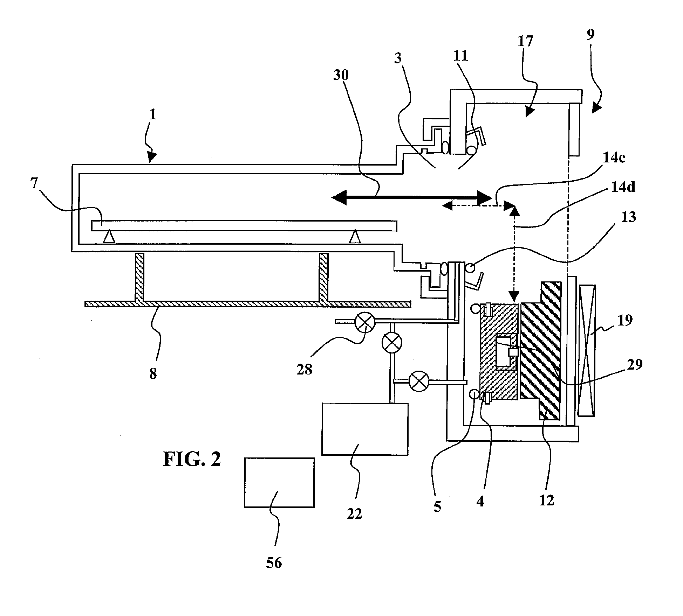

On distingue également un équipement 9, comprenant une paroi périphérique étanche 10 ayant un orifice de sortie 18 obturé par une porte d'équipement 19. L'équipement est associé à une interface 17 étanche, comprenant une ouverture de passage 11 obturée par une porte d'interface 12 assortie de moyens d'étanchéité frontale de porte d'interface 13. Des moyens d'actionnement de porte 14, schématiquement illustrés par une ligne en traits mixtes, sont prévus dans l'interface 17 pour déplacer la porte de boîte 4 et la porte d'interface 12 entre une position fermée illustrée sur la figure 1 et une position ouverte déportée vers l'intérieur de l'interface 17 comme illustré sur la figure 2. Des moyens de verrouillage de porte d'interface 12f permettent de verrouiller sélectivement la porte d'interface 12 en position fermée.

Sur la figure 1, la boîte de transport 1 est illustrée en position d'accouplement sur l'interface 17, la porte de boîte 4 étant en regard de la porte d'interface 12. Dans cette position, un moyen de retenue 15, comprenant une mâchoire supérieure 15a et une mâchoire inférieure 15b, solidarise de manière réversible la boîte de transport 1 contre la paroi entourant l'ouverture de passage 11. Un moyen d'étanchéité frontale d'interface 16 est interposé entre la boîte de transport 1 et l'interface 17 pour assurer, entre la boîte de transport 1 et la paroi entourant l'ouverture de passage 11, une étanchéité vis-à-vis de l'atmosphère extérieure autour de l'ouverture d'entrée-sortie 3 et de l'ouverture de passage 11.

On comprend que le moyen de retenue 15 sollicite la boîte de transport 1 en direction de l'interface 17, en comprimant le moyen d'étanchéité frontale d'interface 16, qui est éventuellement déformé comme représenté.

Dans la réalisation illustrée sur la figure 1, le moyen d'actionnement de porte 14 est disposé dans l'interface 17 rapportée et fixée à l'entrée de l'équipement 9. L'interface 17 comprend, à l'opposé de l'ouverture de passage 11, l'orifice de sortie 18 qui met l'interface 17 en communication avec l'intérieur de l'équipement 9, lequel équipement 9 étant muni de la porte d'équipement 19 pour obturer sélectivement l'orifice de sortie 18.

En alternative, on peut concevoir que le moyen d'actionnement de porte 14 est déporté latéralement vers l'extérieur, et/ou que l'interface 17 se trouve directement intégrée à l'équipement 9, sans porte d'équipement 19.

La porte de boîte 4 est associée à des moyens de verrouillage de porte de boîte 20, actionnables par des moyens d'actionnement montés dans l'interface 17, pour verrouiller et déverrouiller la porte de boîte 4 en position fermée dans laquelle elle obture l'ouverture d'entrée-sortie 3. Les moyens de verrouillage de porte de boîte 20 comprennent par exemple des loquets, portés par la porte de boîte 4, actionnés en coulissement radial par des moyens d'accouplement 29 eux-mêmes actionnés depuis l'interface 17, et s'engageant dans des logements prévus dans la paroi périphérique étanche 2 de la boîte de transport 1.

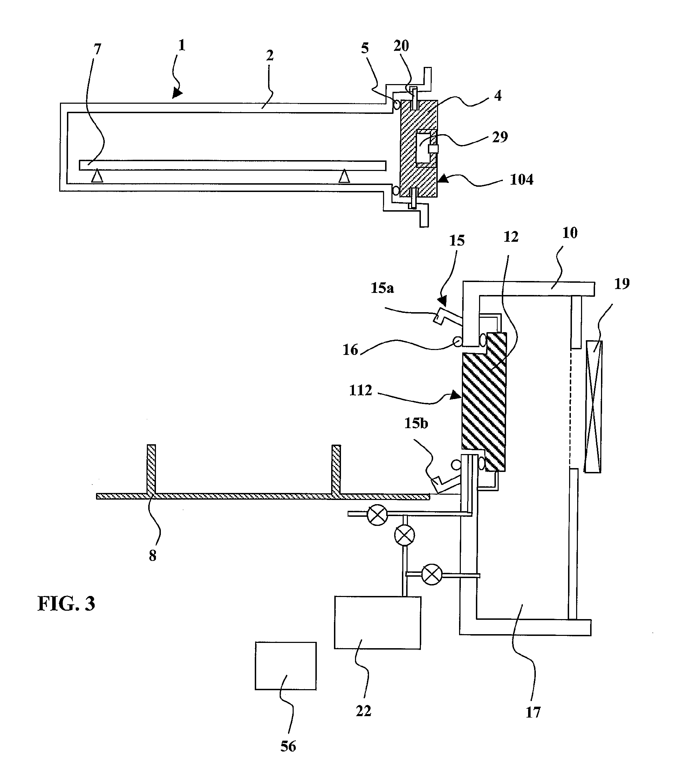

En position fermée illustrée sur les figures 1 et 3 par exemple, la porte de boîte 4 est retenue par les moyens de verrouillage de porte de boîte 20, et elle maintient à l'état élastiquement comprimé les moyens d'étanchéité frontale de porte de boîte 5. Sur ces figures, les moyens d'étanchéité frontale de porte de boîte 5 sont représentés déformés par la compression, leur épaisseur axiale (horizontale sur les figures) étant réduite.

Ainsi, les moyens d'étanchéité frontale de porte de boîte 5 sont élastiquement compressibles, à la fois pour garantir une bonne étanchéité, et pour faciliter le verrouillage et le déverrouillage de la porte.

Le moyen d'étanchéité frontale d'interface 16 constitue un moyen d'étanchéité périphérique qui isole de l'atmosphère une zone d'accouplement entre les faces frontales respectives de la boîte de transport 1 et de l'interface 17 autour des ouvertures de passage 11 et d'entrée-sortie 3. Sur la figure 1, on a illustré cette zone d'accouplement, contenant les portes de boîte 4 et d'interface 12 et un volume périphérique 21. Le volume périphérique 21 est un volume gazeux, emprisonné dans la zone inter-joints entre la porte de boîte 4, la porte d'interface 12, le moyen d'étanchéité frontale de porte de boîte 5, le moyen d'étanchéité frontale de porte d'interface 13, et le moyen d'étanchéité frontale d'interface 16. Lorsqu'on ouvre la porte de boîte 4 et la porte d'interface 12, ce volume 21 se trouve directement en communication avec la cavité interne 6 de la boîte de transport 1 et avec l'intérieur de l'interface 17. Initialement, ce volume périphérique 21 se trouve à la pression atmosphérique, et il apparaît nécessaire de prévoir des moyens de pompage pour faire le vide dans le volume périphérique 21 avant l'ouverture des portes.

Pour cela, on prévoit des moyens de pompage de liaison.

Les moyens de pompage de liaison comprennent une canalisation de pompage de liaison 23, dont l'orifice d'entrée 23a communique avec le volume périphérique 21 entre le moyen d'étanchéité frontale d'interface 16 et le moyen d'étanchéité frontale de porte d'interface 13, et dont la sortie est connectée à un dispositif de pompage à vide tel qu'une pompe 22, avec interposition d'une vanne de commande de pompage de liaison 24.

Le dispositif de pompage à vide est aussi connecté, par une canalisation de pompage d'interface 25, à l'espace intérieur de l'interface 17, avec interposition d'une vanne de commande de pompage d'interface 26.

Les moyens de pompage de liaison sont en outre adaptés pour établir sélectivement, dans le volume périphérique 21, une pression sensiblement égale à la pression environnante à l'extérieur du dispositif. Pour cela, une canalisation d'équilibrage 27, munie d'une vanne d'équilibrage 28, relie la canalisation de pompage de liaison 23 et/ou le volume périphérique 21 avec l'extérieur du dispositif.

Les moyens de pompage de liaison comprennent en outre des moyens de commande tels qu'un microprocesseur ou microcontrôleur 56, afin de piloter les pressions gazeuses régnant dans l'interface 17 et dans le volume périphérique 21. Pour cela, le microprocesseur ou microcontrôleur 56 pilote la pompe 22 ainsi que les vannes 24, 26 et 28, en fonction de signaux reçus de différents capteurs, non illustrés sur les figures, et en fonction d'un programme enregistré. De la sorte, les moyens de pompage de liaison, constitués par l'ensemble des moyens de pompage 22 à 28 et par les moyens de commande 56, sont adaptés pour établir des équilibrages de pressions lors des différentes étapes de fonctionnement.

Par exemple, lors de l'étape d'arrimage d'une boîte de transport 1 contre l'interface 17, le volume périphérique 21 est tout d'abord à la pression atmosphérique, alors que l'atmosphère intérieure de la boîte de transport 1 peut être à une première pression basse, et l'interface 17 peut être à une seconde pression basse éventuellement différente de la pression dans la boîte de transport 1. Avant l'ouverture des portes de boîte 4 et d'interface 12, les moyens de pompage de liaison 22-28, 56 peuvent établir, dans le volume périphérique 21, une pression gazeuse sensiblement égale à la pression dans la boîte de transport 1.

Si nécessaire, les moyens de pompage de liaison 22-28, 56 établissent, dans l'interface 17, une pression gazeuse sensiblement égale à la pression dans la boîte de transport 1, la porte d'équipement 19 étant fermée. On peut ensuite ouvrir les portes de boîte 4, d'interface 12. Ensuite, les moyens de pompage de liaison établissent sélectivement, dans l'interface 17 et dans la boîte de transport 1, alors que les portes de boîte 4 et d'interface 12 sont ouvertes tandis que la porte d'équipement 19 est fermée, une pression gazeuse sensiblement égale à la pression dans l'équipement 9. On peut alors ouvrir la porte d'équipement 19, pour le transfert des objets plats entre la boîte de transport 1 et l'équipement 9.

Au cours d'une étape ultérieure, par exemple après transfert des objets plats dans la boîte de transport 1, on ferme la porte d'équipement 19. Les moyens de pompage de liaison 22-28, 56 peuvent alors être adaptés pour établir sélectivement, dans l'interface 17 et dans la boîte de transport 1, alors que les portes de boîte 4 et d'interface 12 sont encore ouvertes, une pression gazeuse sensiblement égale à la pression désirée dans la boîte de transport 1. On ferme ensuite les portes de boîte 4 et d'interface 12, les moyens de pompage de liaison remettant alors à la pression atmosphérique le volume périphérique 21, pour autoriser le désaccouplement de la boîte de transport 1 à l'écart de l'interface 17.

On distingue en outre, sur la figure 1, des moyens d'accouplement détachables 29, prévus dans la porte de boîte 4 et dans la porte d'interface 12, commandés par les moyens d'actionnement de porte 14 pour solidariser de manière réversible la porte de boîte 4 contre la porte d'interface 12. A l'état accouplé, illustré sur la figure 1, la porte de boîte 4 se déplace en bloc avec la porte d'interface 12 entre la position fermée et la position ouverte.

Les moyens d'accouplement détachables 29 peuvent être constitués de manière connue en soi, comme dans les interfaces actuelles d'adaptation de boîte de transport de type FOUP, avec une clé prévue sur la porte d'interface 12 et qui pénètre dans un logement approprié de la porte de boîte 4. En pratique, on peut prévoir plusieurs verrous répartis sur la surface des portes.

Considérons en succession les figures 1 à 3, qui illustrent l'état du dispositif au cours des différentes étapes de fonctionnement. Sur la figure 1, la boîte de transport 1 est accouplée à l'interface 17, les portes 4 et 12 étant fermées et verrouillées. Les moyens d'accouplement détachables 29 solidarisent la porte de boîte 4 sur la porte d'interface 12. On a préalablement fait le vide dans le volume périphérique 21, par la pompe 22, la vanne de commande de pompage de liaison 24 et la canalisation de pompage de liaison 23.

A partir de cet état, pour ouvrir la boîte de transport 1 et la mettre en communication avec l'équipement 9, on actionne les moyens de verrouillage 20 et 12f pour déverrouiller les portes 4 et 12, et les moyens d'actionnement de porte 14 déplacent en bloc les deux portes 4 et 12 selon deux mouvements partiels, tout d'abord selon un mouvement partiel axial 14c entre la position fermée et une position de retrait axial vers l'intérieur de l'interface 17, puis latéralement à l'écart de l'ouverture de passage 11 en un mouvement partiel transversal 14d entre la position de retrait axial et une position escamotée latéralement qui libère le passage des objets plats 7 entre la boîte de transport 1 et l'équipement 9, le dispositif prenant ensuite l'état illustré sur la figure 2. Simultanément ou en succession, on ouvre la porte 19 de l'équipement 9. Dans ces conditions, le passage est entièrement libéré pour le déplacement de l'objet plat 7, comme illustré par la double flèche 30.

Ensuite, pour refermer la boîte de transport 1, les moyens d'actionnement de porte 14 déplacent les portes 4 et 12 en mouvement inverse, pour revenir dans la position illustrée sur la figure 1. On actionne alors les moyens de verrouillage de porte de boîte 20 et les moyens de verrouillage de porte d'interface 12f.

En manoeuvrant la vanne d'équilibrage 28, on rétablit la pression atmosphérique dans le volume périphérique 21. On actionne les moyens d'accouplement détachables 29 pour déverrouiller la porte de boîte par rapport à la porte d'interface 12, et on manoeuvre enfin le moyen de retenue 15 pour libérer la boîte de transport 1, que l'on peut alors déplacer à l'écart de l'interface 17, comme illustré sur la figure 3. Dans cet état, la boîte de transport 1 est fermée de manière étanche par la porte de boîte 4 qui est retenue de manière sûre par les moyens de verrouillage de porte de boîte 20.

Selon l'invention, lors de la fermeture de la boîte de transport 1, on prévoit des moyens pousseurs pour appliquer sur la porte de boîte 4 une poussée axiale vers l'intérieur de la boîte de transport 1, comprimant ainsi les moyens d'étanchéité frontale de porte de boîte 5. Par exemple, les moyens pousseurs peuvent être constitués par les moyens d'actionnement de porte 14, structurés de façon à produire cette poussée axiale, et associés aux moyens de verrouillage de porte d'interface 12f et au moyen de retenue 15. En alternative, on peut prévoir des moyens pousseurs spécifiques, comme on le décrira plus loin.

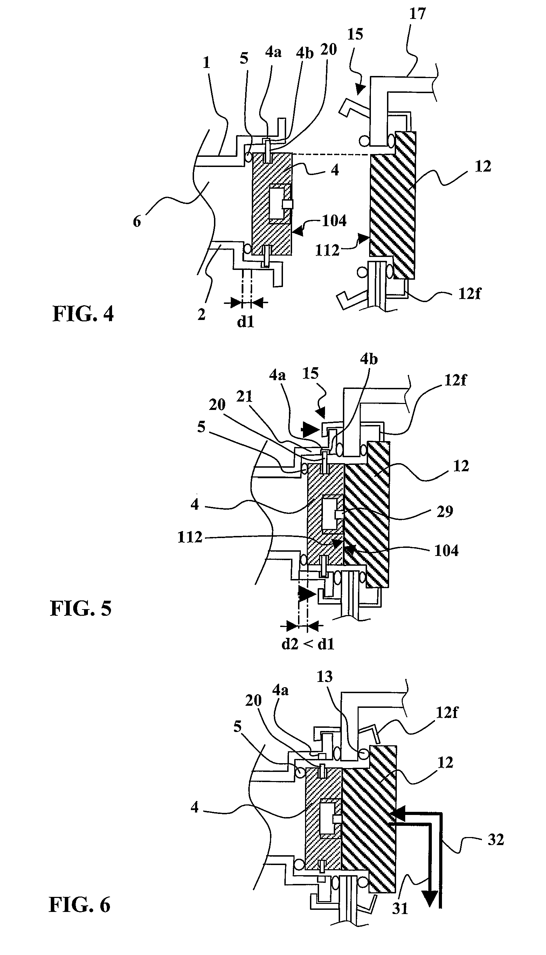

On considère maintenant les figures 4 à 6, qui explicitent une fonction supplémentaire possible des moyens pousseurs, selon un mode de réalisation particulier de l'invention.

Sur la figure 4, qui est une vue partielle des zones d'ouverture de la boîte de transport 1 et de l'interface 17, on retrouve les mêmes éléments que dans les figures 1 à 3, et ces mêmes éléments sont repérés par les mêmes références numériques.

Le moyen de verrouillage de porte de boîte 20 est illustré schématiquement sous forme de verrous à déplacement latéral, prévus dans la porte de boîte 4, et qui peuvent s'engager dans des logements 4a de la paroi périphérique étanche 2 de la boîte de transport 1. A l'état verrouillé, illustré sur la figure 4, la porte de boîte 4 étant retenue par les moyens de verrouillage 20, les verrous viennent en appui dans le logement 4a selon sa face 4b la plus distale de la boîte de transport 1, laissant un jeu vers l'intérieur. Le moyen d'étanchéité de porte de boîte 5 est à l'état relativement comprimé, assurant une bonne étanchéité de la cavité intérieure 6 vis-à-vis de l'atmosphère extérieure. L'état de compression axiale du moyen d'étanchéité frontale de porte de boîte 5 est illustré par la distance d1.

Simultanément, la porte d'interface 12 est verrouillée sur la paroi de l'interface 17 par les moyens de verrouillage de porte d'interface 12f.

La pression atmosphérique ambiante participe à la retenue de la porte de boîte 4 sur la paroi périphérique étanche 2, pour le maintien fermé de la porte de boîte 4. Mais le moyen de verrouillage de porte de boîte 20 assure une plus grande sécurité de fermeture, son action n'étant pas dépendante de la pression régnant dans la cavité intérieure 6 de la boîte de transport 1.

Sur la figure 5, on a rapproché la boîte de transport 1 pour venir l'appliquer contre la face frontale de l'interface 17. La face externe 104 de la porte de boîte 4 vient alors directement en appui contre la face externe 112 de la porte d'interface 12, qui forme elle-même une butée axiale, et qu'elle recouvre de préférence sans jeu et sans dépassement.

Le moyen de retenue 15 force la boîte de transport 1 contre l'interface 17, de sorte que la butée constituée par la porte d'interface 12 repousse la porte de boîte 4 vers l'intérieur de la boîte de transport 1, selon une faible course qui comprime encore davantage le moyen d'étanchéité frontale de porte de boîte 5 : voir la distance d2 inférieure à d1. Le moyen de verrouillage de porte de boîte 20 se trouve ainsi déporté dans le logement 4a à l'écart de la face 4b distale de logement. Il est alors aisé de manoeuvrer le moyen de verrouillage 20 sans frottement, pour le sortir du logement 4a. Simultanément, on fait le vide dans le volume périphérique 21, et on verrouille les deux portes 4 et 12 l'une à l'autre par l'actionnement des moyens d'accouplement détachables 29.

Le moyen d'actionnement de porte 14 peut alors entraîner les deux portes 4 et 12 selon un mouvement d'ouverture illustré par la flèche 31 sur la figure 6.

Ensuite, pour la fermeture, le moyen d'actionnement de porte 14 déplace les portes 4 et 12 selon un mouvement de fermeture illustré par la flèche 32 sur la figure 6, ramenant les portes 4 et 12 en position fermée en appui frontal respectivement dans l'ouverture d'entrée-sortie 3 et dans l'ouverture de passage 11. On applique, sur les portes 4 et 12, une poussée axiale vers la boîte de transport 1, comprimant le moyen d'étanchéité frontale de porte de boîte 5 et le moyen d'étanchéité frontale de porte d'interface 13, grâce aux moyens pousseurs, et on verrouille les portes respectivement par le moyen de verrouillage de porte de boîte 20 et par le moyen de verrouillage de porte d'interface 12f. On peut alors introduire de l'air dans le volume périphérique 21, rétablissant la pression atmosphérique, on peut déverrouiller les moyens d'accouplement détachables 29, puis libérer la boîte de transport 1 par l'ouverture des moyens de retenue 15, pour retourner à l'état illustré sur la figure 4.

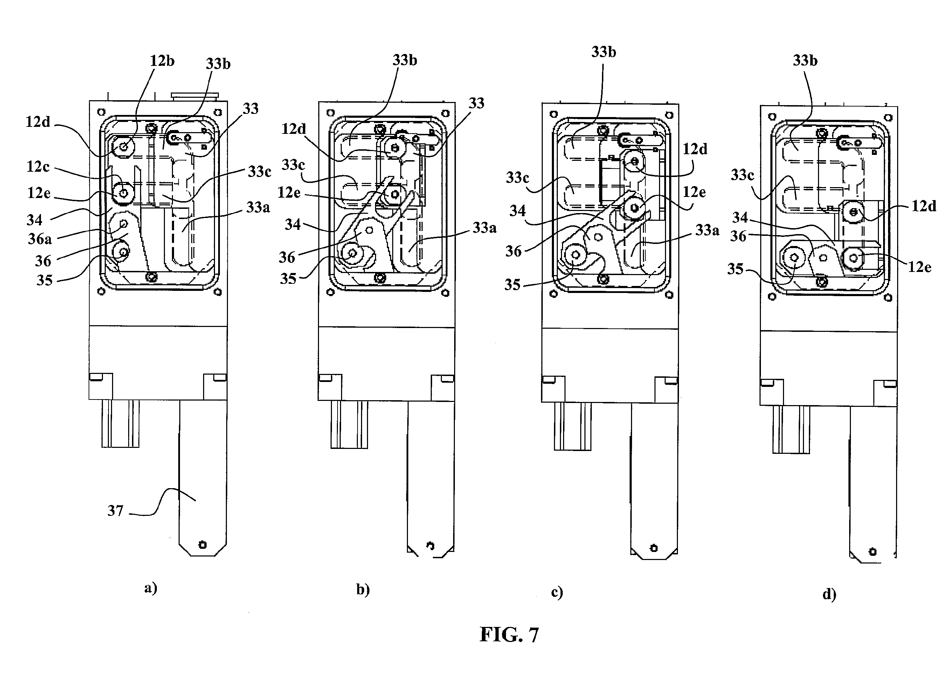

On considère maintenant les figures 7a à 7d qui illustrent une structure possible des moyens d'actionnement de porte. Les figures illustrent ces moyens en vue de côté. La porte d'interface 12 est solidaire de deux axes transversaux 12b et 12c aux deux extrémités desquels sont montés des roulements tels que les roulements 12d et 12e. La même structure est prévue de chaque côté de la porte d'interface 12.

Les roulements 12d et 12e se déplacent dans un chemin de guidage 33 à forme en F (inversé sur la figure) ayant une branche transversale 33a (verticale) et deux branches axiales 33b et 33c (horizontales) déportées transversalement l'une par rapport à l'autre, la première branche axiale 33b se raccordant à l'extrémité supérieure du chemin de guidage 33, tandis que la branche inférieure 33c se raccorde au voisinage de la partie centrale de la branche transversale 33a.

Une fourche 34 est montée rotative autour d'un axe de fourche 35 horizontal, et s'engage sur le roulement 12e. La fourche 34 peut ainsi pivoter autour de l'axe de fourche 35, sous la sollicitation d'une biellette 36 elle-même actionnée par un vérin 37 et couplée par l'axe de biellette 36a.

Lorsque la fourche 34 est verticale, comme illustré sur la figure 7a, les roulements 12d et 12e sont en bout du chemin de guidage 33 vers la gauche, c'est-à-dire en direction de la boîte de transport 1, la porte d'interface 12 étant alors fermée. Par rotation de la fourche 34 vers la droite, comme illustré sur la figure 7b, on déplace axialement la porte d'interface 12 dans le sens de l'ouverture, les roulements 12d et 12e se déplaçant dans les branches axiales 33b et 33c du chemin de guidage 33. Ensuite, par un pivotement supplémentaire de la fourche 34 comme illustré sur les figures 7c et 7d, on déplace la porte d'interface transversalement, les roulements 12d et 12e se déplaçant dans la branche transversale 33a du chemin de guidage 33. Sur la figure 7d, la porte d'interface 12 est alors en position escamotée telle qu'illustrée sur la figure 2.

Les moyens d'actionnement des portes ainsi décrits assurent le déplacement des portes 4 et 12 en deux mouvements partiels, à savoir un mouvement partiel axial entre la position fermée (figure 7a) et une position de retrait axial vers l'intérieur de l'appareil de traitement 9 (figure 7b), et un mouvement partiel transversal entre la position de retrait axial (figure 7b) et une position escamotée latéralement (figure 7d) qui libère le passage des objets plats entre la boîte de transport 1 et l'appareil de traitement 9.

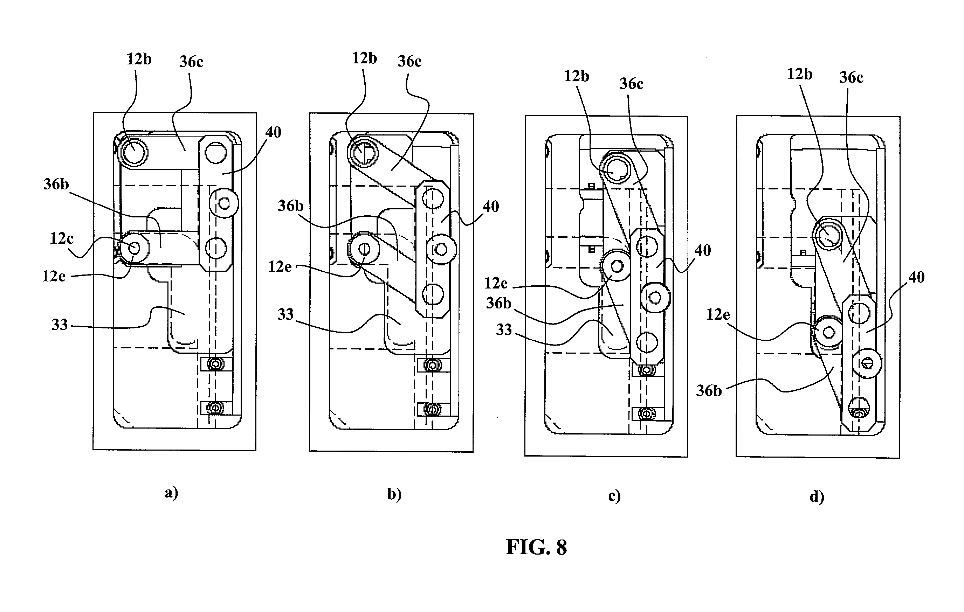

Les figures 8a à 8d illustrent un autre mode de réalisation des moyens d'actionnement de porte d'interface, basé sur un principe de parallélogramme. On retrouve les axes transversaux 12b et 12c solidaires de la porte d'interface, et on retrouve un chemin de guidage 33 sur lequel roule un seul roulement 12e de l'axe transversal 12c. Un chariot 40 coulisse verticalement sous l'action d'un vérin non représenté, et est articulé par deux biellettes 36b et 36c aux deux axes transversaux respectifs 12b et 12c. Le mouvement vertical du chariot 40 produit un double mouvement axial puis transversal de la porte d'interface, comme illustré sur les figures. Simultanément ces moyens d'actionnement de portes assurent l'application de ladite poussée axiale d'intensité suffisante.

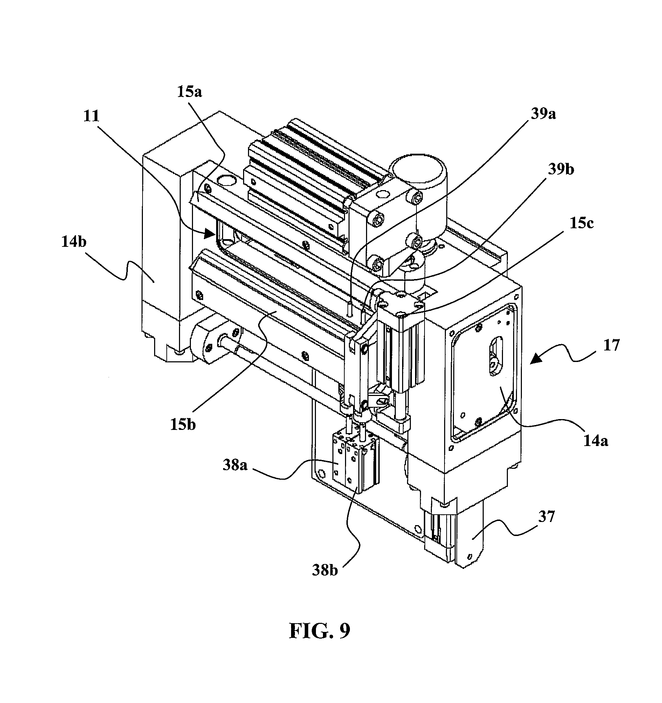

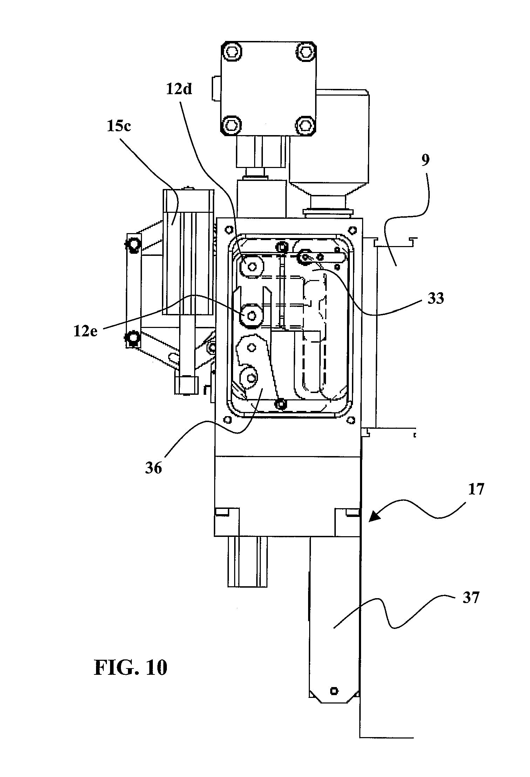

On considère maintenant les figures 9 à 11 qui illustrent un mode de réalisation possible des moyens schématiques illustrés sur les figures précédentes.

Dans ce mode de réalisation, l'invention est implémentée sous forme d'une interface 17 destinée à être fixée à l'entrée d'un équipement non représenté. On distingue l'ouverture de passage 11, et les moyens de retenue de boîte constitués de deux mâchoires supérieures 15a et inférieure 15b, actionnées par un vérin de mâchoire de tenue de boîte 15c. Les moyens d'actionnement de portes sont contenus dans deux boîtiers latéraux 14a et 14b, pilotés par un vérin 37. Deux vérins de verrouillage 38a et 38b actionnent verticalement deux pions de verrouillage respectifs 39a et 39b qui sortent dans l'ouverture de passage 11 pour actionner les moyens d'accouplement détachables prévus entre la porte de boîte 4 et la porte d'interface 12, et pour actionner les moyens de verrouillage de porte de boîte 20.

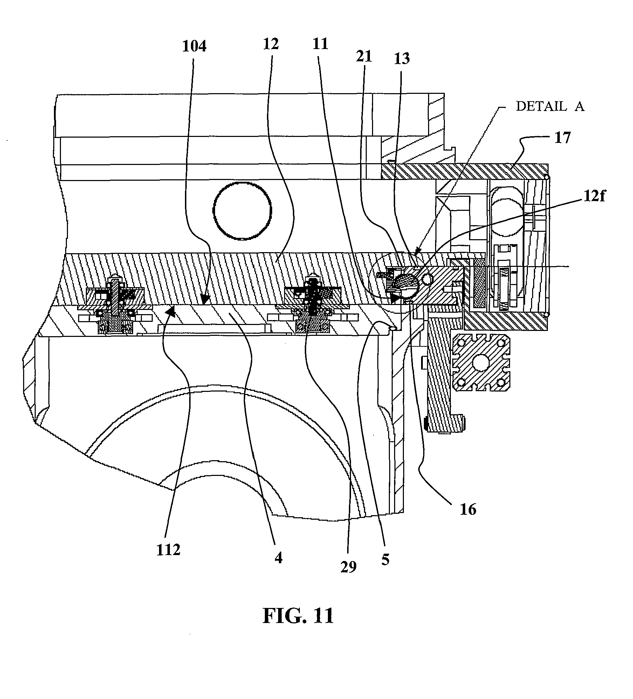

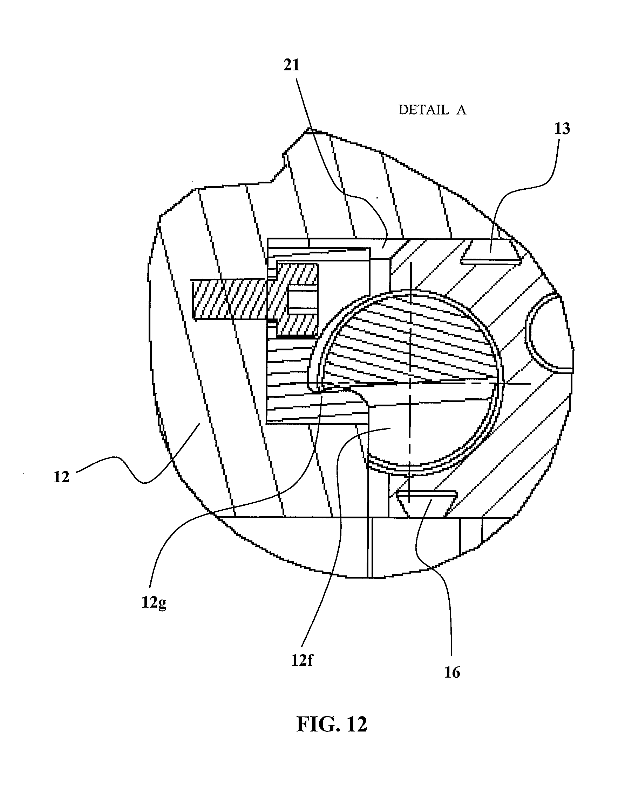

Dans la réalisation illustrée sur les figures 11 et 12, le moyen de verrouillage de porte d'interface 12f est réalisé sous la forme d'un arbre vertical demi-cylindrique, monté latéralement dans la paroi de l'interface 17, et dont un coin peut venir en appui sur une came en développante 12g prévue dans le bord latéral de la porte d'interface 12 lors de la rotation de l'arbre 12f dans le sens inverse des aiguilles d'une montre. Le verrouillage et le déverrouillage se produisent ainsi, par un appui axial sans frottement.

Les arbres 12f constituent simultanément des seconds moyens d'actionnement, distinct des premiers moyens d'actionnement 14, et qui assurent ladite poussée axiale d'intensité suffisante.

On prévoit deux arbres 12f disposés latéralement de part et d'autre de la porte d'interface 12, pour équilibrer les appuis dans le sens axial.

On retrouve, sur les figures 11 et 12, le moyen d'étanchéité frontale d'interface 16, le moyen d'étanchéité frontale de porte de boîte 5, et le moyen d'étanchéité frontale de porte d'interface 13. On voit que, dans la réalisation illustrée, le volume périphérique 21 est réduit au minimum, par le fait que la face externe 112 de la porte d'interface 12 est directement en appui sur la face externe 104 de la porte de boîte 4, qu'elle recouvre sans jeu, et sensiblement sans débordement. Le pourtour de la porte de boîte 4 suit sensiblement le pourtour de la porte d'interface 12 et de l'ouverture de passage 11.

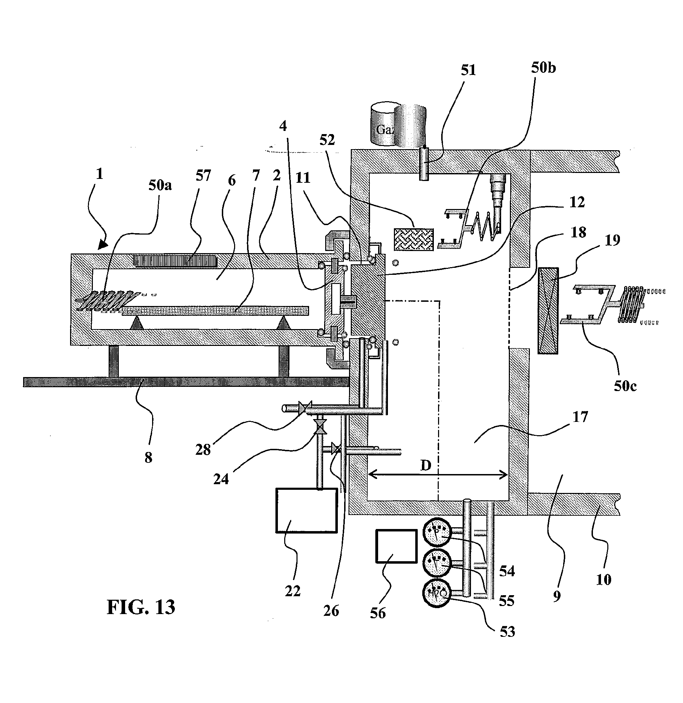

Sur la figure 13, on a illustré d'autres modes de réalisation du dispositif de l'invention. On retrouve, sur cette figure, les éléments essentiels précédemment illustrés sur la figure 1, et ces éléments essentiels sont repérés par les mêmes références numériques.

Pour manipuler les objets plats 7, le manipulateur d'objets plats peut être placé à l'intérieur de la boîte de transport 1, comme illustré par la référence numérique 50a, ou peut être placé dans l'interface 17 comme illustré par la référence numérique 50b, ou peut être placé de préférence dans l'équipement 9 comme illustré par la référence numérique 50c.

Le dispositif support de boîte 8 peut avantageusement être mobile par rapport à l'interface 17, à la fois dans le sens vertical et dans le sens horizontal, pour porter une ou plusieurs boîtes de transport 1 et les déplacer afin de les amener face à l'ouverture de passage 11. L'utilisateur peut ainsi placer plusieurs boîtes de transport 1 sur le dispositif de support 8, et le dispositif peut ainsi prélever en succession plusieurs objets plats pour le traitement dans l'équipement 9.

L'invention prévoit en outre de conditionner efficacement la boîte de transport 1 et l'interface 17 pour réduire encore les risques de pollution des objets plats 7.

On peut avantageusement prévoir à cet effet que l'interface 17 constitue le dispositif qui permet d'abaisser la pression de l'atmosphère intérieure de la boîte de transport 1 jusqu'à une pression suffisamment basse pour réduire le nombre de particules flottant dans l'atmosphère intérieure de la boîte de transport 1. Mais pendant le pompage pour faire le vide dans la boîte de transport 1, il existe certains risques de contamination, par exemple un risque de dépôt d'humidité sur l'objet plat 7, humidité provenant de la vapeur contenue dans l'atmosphère. Pour cela, on peut avantageusement prévoir un dispositif de purge 51 avec de l'air sec ou un autre gaz tel que l'azote.

La contamination particulaire générée de façon externe ou interne à partir de la friction des pièces mécaniques les unes par rapport aux autres, peut également dégrader l'objet plat 7. On peut éviter le risque d'une telle dégradation en utilisant une plaque de thermophorèse 52 placée dans l'interface 17. La plaque de thermophorèse 52 est une plaque refroidie, par exemple par un élément à effet Peltier, créant un gradient de température qui attire les particules. La plaque de thermophorèse 52 est placée en regard de la face active de l'objet plat 7. La présence d'une telle plaque de thermophorèse 52 est particulièrement avantageuse, car l'éventuelle contamination particulaire est en principe générée par la friction entre des pièces mécaniques lors de l'ouverture et de la fermeture des portes.

Le dispositif de purge 51 peut réduire la contamination de plusieurs manières : la purge empêche la condensation résultant de l'expansion des gaz lors du pompage, la purge avec un gaz neutre peut ralentir le taux d'expansion de gaz et peut réduire la pression partielle de vapeur d'eau initialement contenue dans la boîte de transport 1 et l'interface 17, les particules suspendues dans l'atmosphère intérieure peuvent être balayées par la purge, la contamination moléculaire résultant du dégazage peut être évitée par l'injection du gaz neutre.

Lors du pompage pour la mise au vide de la boîte de transport 1, un pompage rapide peut produire une expansion rapide des gaz, expansion qui résulte en une baisse rapide de la température du gaz et qui peut produire une saturation en vapeur d'eau. On peut éviter cela en combinant une purge de gaz et une vitesse appropriée de pompage. L'optimisation de la vitesse de pompage et de la quantité de purge peut être pilotée en installant un capteur d'humidité 53, un capteur de pression 54 et éventuellement un capteur de température 55, surveillant l'état de l'atmosphère intérieure de l'interface 17. Un contrôleur 56 peut ajuster automatiquement la vitesse de pompage en fonction des signaux reçus des capteurs 53-55 pour optimiser la baisse de pression. Le contrôleur 56 peut être à base d'un microcontrôleur ou d'un microprocesseur, selon les besoins.

La pompe à vide 22 peut être entraînée par un moteur à vitesse variable qui peut commander la vitesse de la pompe. En débutant le pompage avec une vitesse relativement faible au cours d'une étape préalable, on réalise un pompage doux, qui évite la condensation de vapeur d'eau. Une pompe à vitesse variable est avantageuse contre la contamination particulaire, puisqu'elle ne requiert aucune vanne de commande de pression par déplacement. On sait que les vannes de commande de pression sont une source importante de contamination particulaire.

Le contrôleur 56 est couplé à différents capteurs installés dans l'interface 17 pour commander la quantité de gaz d'injection, la vitesse de pompage, et la force de la plaque de thermophorèse. Grâce à cela, on peut éviter la condensation d'eau en ajustant la vitesse de la pompe. Avant d'ouvrir l'interface, les pressions dans l'interface et l'objet plat 7 doivent être égales. Le contrôleur 56 peut établir cette égalité en ajustant la vitesse de la pompe et/ou la quantité de purge.

La traçabilité peut être améliorée en associant un code à barres ou une identification par infrarouges à chaque boîte de transport 1. Ainsi, sur la figure, on a illustré le code à barre 57 sur la paroi périphérique de la boîte de transport 1. Cela permet d'éviter le risque d'une contamination transversale entre différentes chambres de procédés ou équipements 9.

On comprend que les fonctions données à l'interface 17 peuvent être relativement nombreuses. Pour gérer les cycles de conditionnement des boîtes de transport 1, on peut avantageusement prévoir un automate, à base du contrôleur 56, permettant de contrôler les moyens de pompage, le fonctionnement des portes, les manipulateurs d'objets plats, le dispositif de purge 51, les moyens de verrouillage.

Le dispositif de l'invention peut être utilisé comme moyen de mise de la boîte de transport 1 à une pression appropriée, soit au vide, soit à une autre pression. Pour cela, l'atmosphère intérieure de la boîte de transport 1 est a priori à la pression atmosphérique. On met également l'interface à la pression atmosphérique, et on met en communication l'espace intérieur de la boîte et l'espace intérieur de l'interface. Ensuite, les moyens de pompage de l'interface, et le dispositif de purge 51, effectuent un conditionnement de la boîte de transport 1 et de l'interface 17, en les amenant à la pression appropriée, et en évitant les turbulences et les condensations ou cristallisations d'humidité.

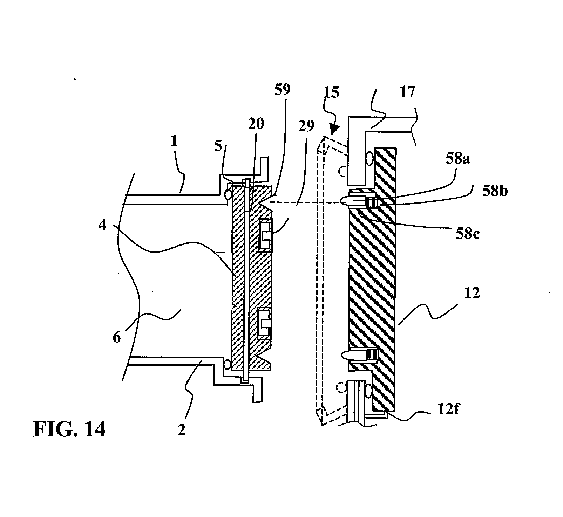

La figure 14 représente une vue de dessus du dispositif selon l'invention selon un mode de réalisation particulier comportant des moyens de centrage. Pour rattraper un décentrage initial de la porte de boite 4 par rapport à la boite 1, il est nécessaire de maintenir la porte de boite 4 et la porte d'interface 12 parallèles et centrées lorsqu'elles sont à l'état accouplé. Pour cela, on adapte des moyens de centrage 58 placés dans la porte d'interface 12 et des moyens de centrage correspondants 59 placés dans la porte de la boite 4 pour guider et maintenir la porte de boite 4 vers la porte d'interface 12 de manière centrée à l'état accouplé.

Les moyens de centrage 58 prévus dans la porte d'interface 12 comprennent préférentiellement deux ensembles comprenant chacun un pion 58a à tête sphérique et un ressort 58b logé dans le logement 58c de la porte d'interface 12 prévu à cet effet. Le logement 58c permet de guider le pion dans l'axe. Le ressort 58b est disposé à la base du pion 58a dans le logement 58c. Les moyens de centrage 58 de la porte d'interface 12 sont situés de préférence à proximité des moyens d'accouplement détachables 29 et à l'extérieur. Cette disposition permet de mieux contrôler le parallélisme des portes 4, 12 entre elles.

En effet, les moyens d'accouplement détachables 29 sont prévus suffisamment larges pour garder parallèles verticalement les deux portes 4, 12. Les moyens de centrage 58 coopèrent alors avec les moyens d'accouplement détachables 29 pour le maintien parallèle des portes d'interface 12 et de boite 4 à l'état accouplé.

Les moyens de centrage 59 prévus dans la porte de boite 4 comprennent préférentiellement deux logements correspondants aux moyens de centrage 58 de la porte d'interface 12. Ces logements sont adaptés pour recevoir les pions 58a des moyens de centrage 58 de la porte d'interface 12. Ces logements sont préférentiellement en forme de cône, ce qui permet de recevoir et bloquer la tête du pion 58a de la porte d'interface 12.

Lorsque les deux portes 4, 12 sont accouplées, au moment où les moyens pousseurs 12f sont relâchés, les moyens d'étanchéité frontale 5 de porte de boite 4 et ceux 13 de porte d'interface 12 se décompriment. Les ressorts 58b prévus dans les moyens centreurs 58 de la porte d'interface 12 relâchent leur tension permettant d'appliquer une force sur les pions 58a. Les pions 58a vont être guidés par les moyens de centrage 59 prévus dans la porte de boite 4 de manière à glisser sensiblement vers le centre du cône s'il y a décentrage. Simultanément, la décompression des moyens d'étanchéité 5 provoque le recul de la porte de boite 4 et les moyens d'accouplement détachables 29 viennent en contact avec l'intérieur de leurs logements dans la porte de boite 4.

La raideur du ressort 58b des moyens de centrage 58 prévus dans la porte d'interface 12 est choisie de telle sorte que la force qu'il exerce sur le pion 58a soit supérieure à la force de friction des moyens d'accouplement détachables 29 dans leurs logements. Les moyens d'accouplement détachables 29 peuvent alors glisser dans leurs logements pour rattraper le mouvement de la tête du pion 58a. La porte de la boite 4 est ainsi réajustée jusqu'à sa position centrée.

De cette manière, les moyens de centrage 58, 59 permettent un guidage de la porte de boite 4 latéralement et en hauteur tel que les deux portes 4, 12 soient parfaitement centrées et maintenues parallèles l'une par rapport à l'autre.

Dans la description qui précède et dans les dessins, les moyens de pompage de liaison 22-28, 56, et leur application éventuelle au conditionnement de l'interface 17 et/ou de la boîte de transport 1, sont présentés en association avec les moyens d'actionnement de portes 14 et les moyens d'étanchéité 5 élastiquement compressibles. On pourra toutefois prévoir, selon l'invention, que de tels moyens de pompage de liaison et leur application peuvent être avantageusement utilisés de façon indépendante.

La présente invention n'est pas limitée aux modes de réalisation qui ont été explicitement décrits, mais elle en inclut les diverses variantes et généralisations qui sont à la portée de l'homme du métier.

## Revendications

1. Dispositif de transport d'objets plats (7) tels que des plaquettes ou masques vers ou à l'écart d'un équipement (9), comprenant :
- des boîtes de transport (1) ayant chacune une paroi périphérique étanche (2) à ouverture d'entrée-sortie (3) obturable par une porte de boîte (4) à moyens d'étanchéité frontale de porte de boîte (5),
- à l'entrée de l'équipement (9), une interface (17) munie d'une ouverture de passage (11) obturable par une porte d'interface (12) à moyens d'étanchéité frontale de porte d'interface (13),
- des moyens d'étanchéité périphérique (16) pour isoler de l'atmosphère extérieure une zone d'accouplement entre les faces frontales de la boîte de transport (1) et de l'interface (17) autour des ouvertures de passage (11) et d'entrée-sortie (3),
- des moyens d'actionnement de portes (14), adaptés dans l'interface (17), pour déplacer la porte de boîte (4) et la porte d'interface (12) entre une position fermée et une position ouverte déportée vers l'intérieur de l'interface (17),
- des moyens de verrouillage de porte de boîte (20), prévus dans la boîte de transport (1), actionnables par des moyens d'actionnement montés dans l'interface (17), pour verrouiller et déverrouiller sélectivement la porte de boîte (4) en position fermée dans laquelle elle obture l'ouverture d'entrée-sortie (3),
**caractérisé en ce que** ledit dispositif, étant destiné au transport d'objets sous atmosphère à basse pression, comprend en outre
- des boîtes de transport (1) qui sont structurées pour supporter mécaniquement la pression atmosphérique externe en présence d'un vide dans sa cavité interne (6),
- des moyens pousseurs (14, 15, 12f), adaptés dans l'interface (17) pour appliquer sur la porte de boîte (4) une poussée axiale vers l'intérieur de la boîte de transport (1), pour comprimer les moyens d'étanchéité frontale de porte de boîte (5),
- des moyens d'étanchéité frontale de porte de boîte (5) élastiquement compressibles, et agencés pour être maintenus élastiquement comprimés par la porte de boîte elle-même retenue par les moyens de verrouillage de porte de boîte (20) lorsque la porte de boîte (4) est en position fermée verrouillée.

2. Dispositif selon la revendication 1, dans lequel les moyens pousseurs (14, 15, 12f) permettent d'appliquer sur la porte de boîte (4) une poussée axiale d'intensité suffisante qui comprime les moyens d'étanchéité frontale de porte de boîte (5) au-delà de la compression assurée par les moyens de verrouillage de porte de boîte (20).

3. Dispositif selon la revendication 2, dans lequel les moyens pousseurs (14, 15, 12f) sont adaptés pour :
- lors d'une étape de verrouillage de la porte de boîte (4), appliquer ladite poussée axiale d'intensité suffisante sur la porte de boîte (4), puis actionner les moyens de verrouillage de porte de boîte (20) pour verrouiller la porte de boîte (4), et enfin relâcher ladite poussée axiale,
- lors d'une étape de déverrouillage de la porte de boîte (4), appliquer ladite poussée axiale d'intensité suffisante sur la porte de boîte (4), puis actionner les moyens de verrouillage pour déverrouiller la porte de boîte (4), et enfin relâcher ladite poussée axiale.

4. Dispositif selon l'une des revendications précédentes, dans lequel des moyens d'accouplement détachables (29) sont prévus en outre dans la porte de boîte (4) et dans la porte d'interface (12), commandés par les moyens d'actionnement de porte (14), pour solidariser de manière réversible la porte de boîte (4) contre la porte d'interface (12), de sorte que, à l'état accouplé, la porte de boîte (4) se déplace en bloc avec la porte d'interface (12) entre la position fermée et la position ouverte.

5. Dispositif selon la revendication 4, dans lequel :
- les moyens d'étanchéité frontale de porte d'interface (13) sont élastiquement compressibles,
- à l'état accouplé, la poussée axiale d'intensité suffisante produit simultanément la compression du moyen d'étanchéité frontale de porte d'interface (13).

6. Dispositif selon l'une des revendications 4 ou 5, dans lequel les moyens d'actionnement de porte comprennent :
- des premiers moyens d'actionnement (14) assurant le déplacement des portes entre les positions ouverte et fermée,
- des seconds moyens d'actionnement (12f), distincts des premiers moyens d'actionnement (14), et assurant ladite poussée axiale d'intensité suffisante.

7. Dispositif selon l'une des revendications 4 ou 5, dans lequel des mêmes moyens d'actionnement de porte (14) assurent à la fois le déplacement des portes entre les positions ouverte et fermée et l'application de ladite poussée axiale d'intensité suffisante.

8. Dispositif selon l'une des revendications 4 à 7, comprenant :
- un moyen de retenue (15), adapté pour solidariser de manière réversible la boîte de transport (1) contre la paroi entourant l'ouverture de passage (11),
- un moyen d'étanchéité frontale d'interface (16) pour assurer, entre la boîte de transport (1) et la paroi entourant l'ouverture de passage (11), une étanchéité vis-à-vis de l'atmosphère extérieure autour des ouvertures d'entrée-sortie (3) et de passage (11) lorsque la boîte de transport (1) est solidarisée contre ladite paroi.

9. Dispositif selon la revendication 8, comprenant en outre des moyens de pompage de liaison (22-28, 56), adaptés pour pomper le volume périphérique (21) gazeux emprisonné dans la zone inter-joints entre la porte de boîte (4), la porte d'interface (12), le moyen d'étanchéité frontale de porte de boîte (5), le moyen d'étanchéité frontale de porte d'interface (13) et le moyen d'étanchéité frontale d'interface (16), lorsque la boîte de transport (1) est solidarisée contre la paroi frontale de l'interface (17) et que les portes (4, 12) sont en position fermée.

10. Dispositif selon la revendication 9, dans lequel, à l'état accouplé, la face externe (104) de la porte de la boîte (4) est directement en appui contre la face externe (112) de la porte d'interface (12) qu'elle recouvre sans jeu et sans dépassement.

11. Dispositif selon l'une des revendications 9 ou 10, dans lequel les moyens de pompage de liaison (22-28, 56) sont adaptés pour établir, dans le volume périphérique (21), une pression gazeuse sensiblement égale à la pression dans la boîte de transport (1) lorsque celle-ci est solidarisée contre l'interface (17) et que les portes de boîte (4) et d'interface (12) sont en position fermée.

12. Dispositif selon l'une des revendications 9 à 11, dans lequel les moyens de pompage de liaison (22-28, 56) sont adaptés pour établir, dans l'interface (17), une pression gazeuse sensiblement égale à la pression dans la boîte de transport (1) lorsque celle-ci est solidarisée contre l'interface (17) et que les portes de boîte (4), d'interface (12) et d'équipement (19) sont en position fermée.

13. Dispositif selon l'une des revendications 9 à 12, dans lequel les moyens de pompage de liaison (22-28, 56) sont adaptés pour établir sélectivement, dans l'interface (17) et dans la boîte de transport (1), lorsque les portes de boîte (4) et d'interface (12) sont ouvertes tandis que la porte d'équipement (19) est fermée, une pression gazeuse sensiblement égale à la pression dans l'équipement (9), ou une pression gazeuse sensiblement égale à la pression désirée dans la boîte de transport (1).

14. Dispositif selon l'une des revendications 9 à 13, dans lequel les moyens de pompage de liaison comprennent une canalisation de pompage de liaison (23), dont l'orifice d'entrée (23a) communique avec le volume périphérique (21) entre le moyen d'étanchéité frontale d'interface (16) et le moyen d'étanchéité frontale de porte d'interface (13), et dont la sortie est connectée à un dispositif de pompage à vide (22).

15. Dispositif selon la revendication 14, dans lequel une vanne de commande de pompage de liaison (24) est interposée dans la canalisation de pompage de liaison (23).

16. Dispositif selon la revendication 15, dans lequel le dispositif de pompage à vide est aussi connecté, par une canalisation de pompage d'interface (25), à l'espace intérieur de l'interface (17) avec interposition d'une vanne de commande de pompage d'interface (26).

17. Dispositif selon l'une des revendications 9 à 16, dans lequel les moyens de pompage de liaison (22-28, 56) sont adaptés pour établir, dans le volume périphérique (21), une pression sensiblement égale à la pression environnante à l'extérieur du dispositif.

18. Dispositif selon la revendication 17, dans lequel une canalisation d'équilibrage (27), munie d'une vanne d'équilibrage (28), relie le volume périphérique (21) avec l'extérieur du dispositif.

19. Dispositif selon l'une des revendications précédentes, dans lequel les moyens d'actionnement de porte (14) assurent le déplacement des portes (4, 12) en deux mouvements partiels, à savoir un mouvement partiel axial (14c) entre la position fermée et une position de retrait axial vers l'intérieur de l'interface (17), et un mouvement partiel transversal (14d) entre la position de retrait axial et une position escamotée latéralement qui libère le passage des objets plats (7) entre la boîte de transport (1) et l'équipement (9).

20. Dispositif selon l'une des revendications précédentes, dans lequel les moyens d'actionnement de porte (14) sont prévus dans une interface (17) rapportée à l'entrée de l'équipement (9).

21. Dispositif selon l'une des revendications 4 à 18, dans lequel au moins un moyen de centrage (58, 59) est prévu en outre dans la porte d'interface (12) et/ou dans la porte de la boite (4) pour guider la porte de boite (4) vers la porte d'interface (12), et les maintenir lorsque que les deux portes (4, 12) sont accouplées.

22. Dispositif selon la revendication 21, dans lequel au moins un moyen de centrage (58) est prévu dans la porte d'interface (12) comprenant un pion à tête sphérique (58a) et un ressort (58b) logé dans le logement de la porte d'interface formant guide (58c), et au moins un moyen de centrage (59) est prévu dans la porte de boite (4) comprenant un logement adapté pour recevoir le moyen de centrage (58) correspondant de la porte d'interface (12).
